# EUROPÄISCHE PATENTSCHRIFT

(11) **EP 2 686 865 B1**
(45) Veröffentlichungstag und Bekanntmachung des Hinweises auf die Patenterteilung: **26.07.2017**
(21) Anmeldenummer: 12715616.4
(22) Anmeldetag: 16.03.2012
(51) Int. Cl.: H01J 37/26

(54) **PHASENKONTRASTEINHEIT UND HERSTELLUNGSVERFAHREN DAFÜR**
PHASE CONTRAST UNIT AND FABRICATION METHOD THEREOF
UNITÉ À CONTRASTE DE PHASE ET SON PROCÉDÉ DE FABRICATION

(30) Priorität: 18.03.2011 DE 102011014399
(43) Veröffentlichungstag der Anmeldung: 22.01.2014
(73) Patentinhaber: Stiftung caesar Center of Advanced European Studies and Research, 53175 Bonn (DE)
(72) Erfinder: IRSEN, Stephan, 53225 Bonn (DE); PATTAI, Steffen, 53489 Sinzig (DE); WAMSER, Jörg, 53179 Bonn (DE); KURTH, Patrick, 53332 Bornheim (DE)
(74) Vertreter: Braun-Dullaeus Pannen Patent- und Rechtsanwälte
(86) Internationale Anmeldenummer: PCT/EP2012/054686
(87) Internationale Veröffentlichungsnummer: WO 2012/126839

(56) Entgegenhaltungen:
- EP-A1- 2 159 818
- WO-A1-2010/038534
- US-A1- 2008 296 509
- US-A1- 2010 065 741
- WU M Y ET AL: "TEM study of locally coated nanopore fabricated by ion-beam-induced deposition in a thin membrane", MICRON, PERGAMON, OXFORD, GB, Bd. 41, Nr. 6, 1. August 2010 (2010-08-01) , Seiten 609-614, XP027474012, ISSN: 0968-4328, DOI: 10.1016/J.MICRON.2010.03.009 [gefunden am 2010-08-01]
- HANAI T ET AL: "CHARACTERISTICS AND EFFECTIVENESS OF FOIL LENS FOR CORRECTION SPHERICAL ABERRATION IN SCANNING TRANSMISSION ELECTRON MICROSCOPY", JOURNAL OF ELECTRON MICROSCOPY, JAPANESE SOCIETY FOR ELECTRON MICROSCOPY. TOKYO, JP, Bd. 47, Nr. 3, 1. Januar 1998 (1998-01-01) , Seiten 185-192, XP000801950, ISSN: 0022-0744

## Beschreibung

Die Erfindung betrifft eine Phasenkontrasteinheit zur Verwendung in einem Elektronenmikroskop und ein Verfahren zum Herstellen der Phasenkontrasteinheit. Biologische Proben sind aufgrund ihrer chemischen Zusammensetzung insbesondere in einem Transmissionselektronenmikroskop (TEM) fast transparent, d.h. insbesondere, dass sie den Elektronenstrahl nur schwach streuen und daher nur geringen Bildkontrast erzeugen. Die hauptsächliche Wechselwirkung mit den die Probe durchchdringenden Elektronen besteht in einer Änderung der Phase dieser Elektronen. Phasenänderungen können allerdings nicht direkt sichtbar gemacht werden. Allerdings gibt es Möglichkeiten, die Phasenänderung so zu beeinflussen, dass sie sich in einer Kontraständerung im Bild manifestiert. Die bekannteste dieser Möglichkeiten ist das Defokussieren. Allerdings gehen dabei Bilddetails verloren. Eine weitere Möglichkeit, eine Phasenänderung zur Verbesserung des Bildkontrasts zu nutzen, bieten Phasenkontrastsysteme. Dazu kann die Phase eines Teils des Elektronenstrahls nach dem Durchstrahlen der Probe um einen Betrag von 90° verändert werden, wohingegen ein anderer Teil des Elektronenstrahls unverändert bleibt. Beide Teilstrahlen werden anschließend wieder überlagert. Durch die zusätzliche Phasenveränderung entsteht zwischen den vereinigten Teilstrahlen eine Interferenz, die zu einer Kontraststeigerung im Bild führt.

Bei den derzeit erprobten Phasenkontrasteinheiten (PCS) handelt es sich insbesondere um sogenannte Dünnfilmphasenkontrasteinheiten vom Zernike-Typ oder um elektrostatische Einzellinsen vom Boersch-Typ, z.B gezeigt in der EP 2 159 818 A1. Beide Arten weisen systembedingte Vor- und Nachteile auf. Beim elektrostatischen Boersch-PCS wird der an der Probe nicht gestreute Teil des Elektronenstrahls durch eine kleine Linse geleitet und seine durch ein elektrostatisches Feld verändert. Die an der Probe gestreuten Elektronen werden bleiben unbeeinflusst. In der Bildebene werden beide Teilstrahlen wieder vereinigt. Bei dieser Methode lässt sich die Phasenverschiebung über einen weiten Bereich einstellen. Dies ist insbesondere bei Anwendung im Bereich der Hochauflösungs-Elektronenmikroskopie (HRTEM) vorteilhaft. Durch geeignete Wahl der Phasenverschiebung lässt sich die Elektronenwelle am Austrittspunkt aus der Probe einfach rekonstruieren. Das wiederum kann die Rekonstruktion der genauen Position einzelner Atome in HRTEM Bildern erleichtern. Darüber hinaus passieren die an der Probe getrennten Elektronen keine weitere Materie und werden damit nicht zusätzlich abgeschwächt. Dies ist insbesondere bei der Kryo-Elektronenmikroskopie von Vorteil, da bei dieser Technik gefrorene Proben untersucht werden, die sehr empfindlich gegenüber den sie durchstrahlenden Elektronen sind. Eine zusätzliche Schwächung des Elektronenstrahls sollte daher vermieden werden. Allerdings benötigt die elektrostatische Boersch-Linse eine Haltestruktur. Da diese und auch die Linse selbst für den Elektronenstrahl nicht transparent sind, schneidet das Boersch-PCS Informationen aus den Bildern heraus. Derzeit lassen sich Boersch-Linsen mit einem Lochdurchmesser von ca. 0,5 bis 1 µm und einer Stegbreite von ca. 1 bis 3 µm herstellen. Hierdurch werden Informationen in einem Bereich von ca. 5 bis 10nm unwiederbringlich aus den Bildern herausgeschnitten. Dieser Größenbereich ist jedoch bei biologischen Proben häufig relevant. Eine Möglichkeit, die aus den Bildern herausgeschnittenen Informationen zu beeinflussen, besteht darin, die hintere Brennebene des TEMs durch eine zusätzliche Linse künstlich zu vergrößern. Dies wurde auch schon erfolgreich in einem TEM-Prototypen realisiert. Dabei wird mit Hilfe einer sogenannten DMU-Linse die hintere Brennebene um ca. den Faktor 5 vergrößert. Die durch die Phasenkontrasteinheit aus dem Bild herausgeschnittenen Informationen verschieben sich nun ein einen Bereich von 15 bis 50nm. Dieser Größenbereich ist in den meisten strukturbiologischen Fragestellungen weniger interessant. Die Realiserung solcher DMU-Linsen kann aber nur in neuen Mikroskopen mit erheblichem technischen Aufwand realisiert werden und ist daher häufig nicht wirtschaftlich.

Das Zernike-PCS benötigt keinen intensiven Eingriff in das Elektronenmikroskop und kann daher leicht nachgerüstet werden. Dabei wird ein in dünner Kohienstoff-Dünnfilm in der hinteren Brennebene der Objektivlinse des Mikroskops installiert. Dabei ist die Dicke des Kohlenstoff-Dünnfilms grundsätzlich von der verwendeten Beschleunigungsspannung abhängig, so dass beim Wechel der Beschleunigungspannnung eine neue Phasenkontrasteinheit einzubauen ist. Zusätzlich verfügt der Kohlenstoffilm über ein Loch, durch das die an der Probe nicht gestreuten Elektronen passieren können. Sämtliche gestreuten Elektronen passieren das Filmmaterial; ihre Phase wird um weitere 90° geschoben. Allerdings werden beim Durchgang durch das PCS auch wieder Elektronen an den Atomen des Kohlenstoffilms gestreut und stehen in der Bildebene nicht mehr zur Bilderzeugung zur Verfügung. Das führt zu einem Intensitätsverlust von ca. 20%. Ferner werden Dünnfilme für Zernicke-PCS bislang ausschließlich aus amorphem Kohlenstoff hergestellt. Solche Kohlenstofffilme sind im Elektronenmikroskop besonders anfällig gegenüber Kontamination. Auch im Hochvakkum eines Elektronenmikroskops befinden sich immer noch Restmoleküle, die bevorzugt auf solchen Kohlestofffilmen kondensieren und diese dabei so verändern, dass der phasenschiebende Effekt beeinflusst wird. Zusätzlich können die Ränder des zentralen Lochs durch den Elektronenstrahl angegriffen werden, wodurch die Phasenplate unbrauchbar wird. In der Praxis hat sich gezeigt, dass kohlenstoffbasierte Phasenfilme insbesondere ohne besondere Behandlung eine Haltbarkeit von wenigen Stunden bis zu einigen Tagen besitzen.

In der DE 10 2006 011 615 A1 ist die Funktionsweise eines Phasenkontrast-Transmissionselektronenmikroskops beschrieben. Dieses Elektronenmikroskop hat ein Objektiv mit einer hinteren Brennebene und eine erste Beugungslinse, die die hintere Brennebene des Objektivs vergrößert in eine Beugungszwischenbildebene abbildet. Es ist ferner eine zweite Beugungsünse vorgesehen, deren Hauptebene in der Nähe der Beugungszwischenbildebene angeordnet ist. Ein phasenverschiebendes Element vom Boersch-Typ ist als Phasenkontrasteinheit vorgesehen, das in oder in der Nähe der Beugungszwischenbildebene angeordnet ist. Die phasenverschiebende Wirkung wird insbesondere durch die hohe Querschnittsdicke erreicht. Ein Gitter dient zur Erdung.

Hiervon ausgehend ist es Aufgabe der vorliegenden Erfindung, eine verbesserte Phasenkontrasteinheit zur Verwendung in einem Elektronenmikroskop, insbesondere Phasenkontrast-TEM, bereit zu stellen. Die der Erfindung zugrundeliegende Aufgabe wird gelöst durch eine Phasenkontrasteinheit zur Verwendung in einem Elektronenmikroskop, umfassend eine Kernschicht, eine erste Oberflächenschicht und ein zweite Oberflächenschicht, wobei die erste und die zweite Oberflächenschicht an entgegengesetzten Seiten der Kernschicht zumindest mittelbar angebracht sind. Die weiteren Oberflächenschichten können vorzugsweise symmetrisch auf beiden Seiten der Kernschicht aufgebracht werden. Die Schichten, nämlich die Kernschicht sowie die Oberflächenschichten, sowie weitere Schichten falls vorhanden, sind durch zumindest ein Loch durchbrochen. Die Schichten sind insbesondere dabei durch das Loch miteinander fluchtend durchbrochen. Die erfindungsgemäße Phasenkontrasteinheit ist dadurch gekennzeichnet, dass die erste und die zweite Oberflächenschicht, die vorzugsweise die äußersten Schichten der Phasenkontrasteinheit darstellen, elektrisch leitend sind und dass die erste und die zweite Oberflächenschicht gegeneinander isoliert sind. Die Oberflächenschichten können vorzugsweise unmittelbar an der Kernschicht angebracht sein. In einer möglichen Ausgestaltung sind keine weiteren Schichten vorgesehen. In einer anderen möglichen Ausgestaltung können aber weitere Schichten vorgesehen sein, wie noch beschrieben wird. Eine weitere Schicht kann auch zwischen einer Oberflächenschicht und der Kernschicht angebracht sein. Oberflächenschichten müssen nicht zwangsläufig die Oberfläche der Phasenkontrasteinheit bilden, sondern können bedeckt sein, insbesondere von Schutzschichten.

Die Phasenkontrasteinheit ist vorzugsweise im wesentlichen scheibenförmig ausgebildet und weist insbesondere im wesentlichen eine gerade zylindrische Form auf. Die Achse des Zylinders ist dabei vorzugsweise senkrecht zu den Seiten der Kernschicht, an denen die Oberflächenschichten angebracht sind. Die Oberflächenschichten sind daher insbesondere im wesentlichen senkrecht zur Zylinderachse ausgerichtet. Auch sind Mantelflächen der zylindrischen Grundformen vorzugsweise im wesentlichen parallel oder koaxial zur Zylinderachse ausgerichtet. Insbesondere sind mehrere Löcher vorgesehen, die die Schicht durchbrechen. Die Löcher sind insbesondere regelmäßig zueinander angeordnet, d.h. insbesondere, dass mehrere Löcher auf einer gemeinsamen Gerade liegen und/oder zumindest ein Loch mehrere Nachbarlöcher aufweist, die den selben Abstand von dem Loch haben. Die Oberflächenschichten bedecken vorzugsweise die entgegengesetzten Seiten der Kernschicht im wesentlichen vollständig, wobei die Löcher von den Oberflächenschichten ausgenommen sind. Der Querschnitt des Zylinders kann um ein Vielfaches größer sein als die Höhe des Zylinders. Die Oberflächenschichten sind im vorzugsweise wesentlichen eben ausgebildet und/oder an ebenen Flächen der Kernschicht angebracht.

Durch die erfindungsgemäße Ausbildung und Anordnung der Oberflächenschichten kann benachbart zur Kernschicht eine definierte Ladung aufgebracht werden, so dass ein definiertes elektrisches Feld innerhalb der Kernschicht oder zwischen den Schichten und anderen Teilen des Mikroskops erzeugt werden kann. Das definierte elektrische Feld insbesondere innerhalb der Kernschicht kann eine verbesserte, insbesondere über den übertragbaren Frequenzraum homogenere, Phasenverschiebung durch die Phasenkontrasteinheit erzeugen, insbesondere bei zugleich verringerter Querschnittsdicke der Kernschicht. Darüber hinaus kann durch das kontrollierte elektrische Feld innerhalb der Kernschicht das Auftreten von Abberationen in der Bildebene reduziert werden.
Der Betrag der Phasenverschiebung kann durch die Ladung, die durch die erste Oberflächenschicht und die zweite Oberflächenschicht aufgebracht werden kann, definiert eingestellt werden. Insgesamt kann sich folglich eine bessere Einstellbarkeit und/oder Homogenität der Phasenverschiebung ergeben.

Ferner kann bei gleichbleibender Phasenverschiebung die Querschnittsdicke der Phasenkontrasteinheit reduziert werden, was sich vorteilhaft auf die Intensitätsverluste durch die Phasenkontrasteinheit auswirken kann. Darüber hinaus kann die erfindungsgemäße Ausbildung und Anordnung der Oberflächenschichten bei unterschiedlichen Beschleunigungsspannungen des TEMs eingesetzt werden, da der Betrag der Phasenverscheibung über die Stärke des angelegten elektrischen Feldes gesteuert werden kann. Ein Umbau oder ein Einbau einer Phasenkontrasteinheit bei Änderung der Beschleunigungsspannung kann damit entfallen.

Vorzugsweise ist an eine oder an beide Oberflächenschichten, die zudem die äußersten Shichten darstellen können, eine elektrische Spannung anlegbar. Dabei wird zumindest an eine der Oberflächenschichten eine definierte Ladung aufgebracht, wodurch sich eine Spannung ausbilden kann. Hierzu können elektrische Kontaktierungsmittel vorgesehen sein, insbesondere eine Mischung aus einem verdampfbaren Polymer und einem feinst dispergierten Edelmetal, vorzugsweise Gold oder Silber. Diese Kontaktierungsmittel können die Oberflächenschichten mit einer Spannungsquelle verbinden. Durch das Anlegen der elektrischen Spannung an die Oberflächenschicht kann dabei zwischen den beiden Oberflächenschichten, also insbesondere innerhalb der Kernschicht, ein elektrisches Feld erzeugt werden, was die bereits beschriebenen Vorteile bewirken kann.

Vorzugsweise ist die Kernschicht aus einem Isolator gebildet. Dieser ermöglicht, dass das elektrische Feld, welches durch die Oberflächenschichten gebildet wird, nicht durch Stromfluss durch die Kernschicht abgebaut wird oder negativ beeinflusst wird. Der Isolator kann durch einen Halbleiter gebildet sein.

Vorzugsweise ist zwischen einer der Oberflächenschichten und der Kernschicht eine oder mehrere Zwischenschichten angeordnet. Dabei kann eine der Zwischenschichten aus einem isolierenden Material gebildet sein, wobei sich insbesondere diamondlike carbon (DLC) oder Alumioniumoxid eignet. Alternativ oder in Kombination kann eine der Zwischenschichten aus einem leitenden Material gebildet sein. Wenn eine Kombination mit leitender und isolierender Schicht vorgesehen ist, ist bevorzugt, wenn die isolierende Zwischenschicht zwischen der leitenden Zwischenschicht und der Oberflächenschicht angeordnet ist. Die leitende Zwischenschicht kann dazu beitragen, dass das elektrisches Feld zwischen den Oberflächenschichten insbesondere im Bereich der Kernschicht verbessert ausgerichtet ist.

Als Material für leitende Schichten eignet sich insbesondere Graphen. Graphen kann in einer sehr dünnen Schichtdicke, zumindest mittelbar, insbesondere unmiteibar, auf die Kernschicht aufgebracht werden, vorzugsweise mit einer Schichtdicke von weniger als 1 nm, insbesondere maximal 0,2nm, was einem Schichtaufbau von wenigen, insbesondere maximal drei Kohlenstoffatomen, entsprechen kann. Aufgrund des spezifischen Aufbaus von Graphen sind weite Nachteile kohlenstoffbasierter Schichten auf Graphen nicht zutreffend. Ferner ist Graphen wenig anfällig gegen Kontamination. Um die Gefahr von Kontaminationen auf der Graphenschicht weiter zu reduzieren, kann eine Graphenschicht von einer Schutzschicht, insbesondere einer Metallschicht, überzogen sein.

Als Material für die Kernschicht eignet sich insbesondere ein amorphes Material, insbesondere ein kohlenstofffreies Material, insbesondere ein amorphes Silicium. Insbesondere Silicium kann gegenüber Kohlenstoff eine Vielzahl von Vorteilen aufweisen. Zunächst ist es möglich, eine phasenverschiebbare Wirkung bei zugleich geringerem Querschnitt der Kernschicht oder insgesamt der Phasenplatte zu erzielen, insbesondere in Kombination mit der elektrischen Aufladbarkeit der Oberflächenschichten und der daraus resultierenden Anlegung des elektrischen Feldes. Ferner ist es insbesondere aufgrund eines Verzichts von kohlenstoffbasierten Werkstoffen möglich, dass die gesamte Phasenkontrasteinheit mit einem Plasmareinigungsverfahren gereinigt wird, insbesondere einem Argon-Sauerstoffplasma. Hierbei können Verunreinigungen, die insbesondere durch Kohlenstoffverbindungen erzeugt werden, weggeätzt werden. Eine solche Reinigung ist bei kohlenstoffbasierten Phasenkontrasteinheiten nicht möglich, da diese die Phasenkontrasteinheit selbst angreifen würden. Hierbei ist insbesondere vorteilhaft, dass Verdickungen an den Rändern der Löcher, die beim Erzeugen der Löcher insbesondere mittels eines fokussierten lonenstrahls erzeugt werden, ebenfalls durch die Plasmareinigung weitgehend beseitigt werden können.

Die Querschnittsdiclce der Kernschicht ist vorzugsweise geringer als 10nm, vorzugsweise maximal 5nm. Unter der Querschnittsdicke wird insbesondere die Streckenlänge innerhalb der Kernschicht bezeichnet, die die Elektronenstrahlen während der bestimmungsgemäßen Verwendung der Phasenkontrasteinheit durchdringen. Die Querschnittsdicke ist insbesondere parallel zur Zylinderachse angeordnet. Durch eine derartig geringe Querschnittsdicke kann der Intensitätsverlust der Elektronenstrahlen, die durch die Phasenkontrasteinheit und insbesondere durch die Kernschicht hindurchtreten, auf insbesondere unter 10% verringert werden. Durch das Aufbringen des elektrisches Feld an die Phasenkontrasteinheit kann trotz der verringerten Querschnittsdicke die phasenverschiebende Wirkung der Phasenkontrasteinheit ausreichend hergestellt werden.

Vorzugsweise beträgt die Querschnittsdicke der Phasenkontrasteinheit, d.h. insbesondere die aufsummierten Querschnittsdicken der Kernschicht sowie aller Oberflächenschichten und möglichen weiteren Schichten, maximal 15nm. Es versteht sich von selbst, dass die angegeben Querschnittsdicke nur dort erforderlich ist, wo die Elektronenstrahlen die Phasenkontrasteinheit bestimmungsgemäß auch durchtreten sollen. Etwaige Halteabschnitte der Phasenkontrasteinheit o.ä. können davon unberührt bleiben.

Der Aufbau, der in der WO2010/023189 A1 (Barton et al.) beschrieben wird, unterscheidet sich grundlegend von dem Aufbau entsprechend der Erfindung. Barton et al. beschreiben einen Dünnfilm, der mit einem Potenzial beaufschlagt wird. Der Feldlinienverlauf in diesem Aufbau wird hauptsächlich in der Ebene des Dünnfilms erfolgen. In der vorliegenden Erfindung hingegenwird ein System aus zwei leitenden Dünnschichten, getrennt durch eine isolierende Schicht aus einem amorphen Material, beschrieben, also eine Art elektronentransparenter Plattenkondensator. Durch diesen Aufbau ist gewährleistet, dass die Richtung des Feldes parallel zur Richtung des Elektronenstrahls ist. Dadurch kann die Isotropie der Phasenverschiebung signifikant verbessert werden. Bei dem in WO2010/023189 A1 beschriebenen System ist zu erwarten, dass zusätzlich zur Verschiebung der Phase auch eine laterale Verschiebung des Elektronenstrahls erfolgen wird. Diese wird sich entweder in einer Bildverschiebung oder einer ortsabhänghigen Fokusverschiebung manifestieren. Diese Aberrationen können mit dem in der vorliegenden Erfindung beschriebenen Aufbau vermieden werden.

Die Erfindung betrifft ferner ein Elektronenmikroskop, welches eine Phasenkontrasteinheit der vorgenannten Art umfasst. Vorzugsweise durchtreten Elektronenstrahlen bei der bestimmungsgemäßen Verwendung in dem Elektronenmikroskop die Phasenkontrasteinheit im Wesentlichen parallel zu deren dünnsten Querschnittsausdehnung.

Die Erfindung betrifft ferner ein Verfahren zum Herstellen einer Phasenkontrasteinheit, insbesondere einer Phasenkontrasteinheit der vorgenannten Art. Das Verfahren umfasst die folgenden Verfahrensschritte: Die Kernschicht wird auf einer ersten Seite mit einer ersten leitenden Oberflächenschicht beschichtet. Auf einer zweiten Seite der Kernschicht wird diese mit einer zweiten leitenden Oberflächenschicht beschichtet. Dabei ist darauf zu achten, dass die erste und die zweite Oberflächenschicht gegeneinander isoliert sind, d.h. insbesondere nicht unmittelbar in elektrisch leitenden Kontakt miteinander geraten. Diese Schritte können zum Aufbringen weiterer Oberflächenschichten wiederholt werden. Nachdem die Seiten der Kernschicht mit den Oberflächenschichten beschichtet wurden, wird zumindest ein Loch durch die Schichten eingebracht. Das Loch durchbricht insbesondere alle Schichten fluchtend und vollständig. Wenn die Phasenkontrasteinheit lediglich die Kernschicht sowie zwei Oberflächenschichten umfasst, werden dann vorzugsweise keine weiteren Schichten aufgebracht. Die bezüglich der Phasenkontrasteinheit beschriebenen Merkmale und Vorteile sind auch auf das Verfahren anwendbar.

Für das Herstellen des zumindest einen Lochs wird vorzugsweise ein insbesondere fokussierter Ionenstrahl verwendet. Durch diesen Ionenstrahl können kontrolliert Oberflächenbereiche der Kernschicht und der Oberflächenschichten sowie ggf. weiterer Schichten abgetragen werden. Da die Schichten sehr dünn sind, kann ein Durchbruch im Schichtaufbau erzeugt werden, welcher ein Loch darstellt.

Insbesondere bei der Bearbeitung mit fokussierten Ionenstrahlen kann es sich ergeben, dass sich Kontaminationen oder Verschmutzungen auf der Phasenkontrasteinheit bilden. Insbesondere im Bereich der Ränder der Löcher können Verdickungen erzeugt werden. Es ist daher vorzugsweise vorgesehen, dass nach dem Einbringen des zumindest einen Lochs die Phasenkontrasteinheit mit einem Plasmareinigungsverfahren gereinigt wird. Dabei eignet sich insbesondere ein Argon-Sauerstoffplasma für die Reinigung der Phasenkontrasteinheit. Dabei können auch insbesondere die Verdickungen, die auf Kohlenstoffverbindungen basieren, weggeätzt werden. Hierbei ist es von Vorteil, wenn die Kernschicht aus einem insbesondere weitgehend kohlenstofffreien Material, insbesondere amorphem Silicium, gebildet ist, weil die Kernschicht sowie die anderen Schichten nicht durch das Plasmareinigungsverfahren angegriffen werden. Insbesondere Kohlenstoff würde hingegen durch die Reinigung mit dem Argon-Sauerstoffplasma oder anderen Plasmareinigungsverfahren weitgehend angegriffen und dabei zerstört werden.

Die Erfindung wird nachfolgend anhand der Figuren näher erläutert. Hierin zeigt
- Figur 1: eine erfindungsgemäße Phasenkontrasteinheit im Querschnitt,
- Figur 2: die Phasenkontrasteinheit nach Figur 1 in Draufsicht,
- Figur 3: die Phasenkontrasteinheit nach Figur 1 während dem Einbringen der Löcher und dem Reinigen mittels eines Plasmareinigungsverfahrens,
- Figur 4: eine Weiterbildung der Phasenkontrasteinheit nach Figur 1,
- Figur 5: eine weitere Weiterbildung der Phasenkontrasteinheit nach Figur 1.

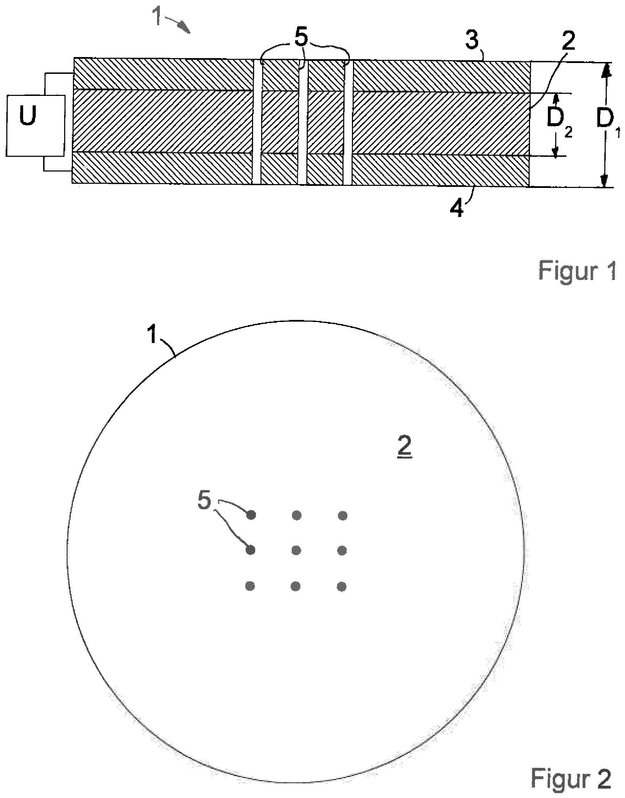

Die Figuren 1 und 2 werden nachfolgend gemeinsam erläutert. Es ist eine Phasenplatte in Form einer Phasenplatte 1 gezeigt. Die Phasenplatte 1 ist im vorliegenden Fall im Wesentlichen von kreiszylindrischer Gestalt, wobei die Höhe des Zylinders um ein Vielfaches geringer ist als der Radius des Zylinders. Insofern ergibt sich eine sehr flache Ausgestaltung der Phasenplatte 1. Die Gesamtdicke D₁ umfasst in etwa 15nm, kann aber auch 14nm oder geringer sein. Diese Phasenplatte ist scheibenförmig. Die Grundform des Zylinders kann aber auch eckig sein oder eine vollständig andere Gestalt aufweisen, die vorzugsweise aber eben ist.

Die Phasenplatte 1 ist durch einen Schichtaufbau gebildet, wobei eine Siliciumschicht 2 von jeweils zwei Oberflächenschichten 3, 4 bedeckt ist. Die Oberflächenschichten 3, 4 bedecken dabei die ebenen parallelen Kreisflächen der Siliciumschicht 2 und bilden jeweils selbst ebene parallele Kreisfläche, die senkrecht auf die Zylinderachse ausgerichtet sind. Parallel zu der Zylinderachse sind insgesamt neun Löcher 5 vorgesehen, die regelmäßig zueinander angeordnet sind. Diese neun Löcher spannen im Wesentlichen ein Lochfeld von 3x3 Löchern auf. Ein Loch 5 weist jeweils einen Durchmesser von in etwa 500nm auf, wobei Durchmesser von ca. 300nm bis in etwa 1µm möglich sind. Die Siliciumschicht 2 ist aus amorphem Silizium gebildet und damit elektrisch isolierend. Die beiden Oberflächenschichten 3, 4 sind aus einem leitenden Metall gebildet und mindestens eine der leitenden Schichten ist an eine Spannungsquelle U angeschlossen, wobei im vorliegende Beispiel beide Oberflächenschichten an die Spannungsquelle angeschlossen sind. Die Oberflächenschichten, zumindest eine davon oder beide, können aber auch aus Graphen, insbesondere monomolekularem Graphen sein. Die Dicke der Oberflächenschicht kann dann durch eine geringe Anzahl von Kohlenstoffatomen gebildet sein, inbesondere maximal 3 Atomen, und/oder maximal 0,2nm dick sein.

Mit Hilfe der Spannungsquelle U kann eine Spannung an mindestens eine der beiden Oberflächenschichten 3, 4 angelegt werden, sodass zwischen den beiden Oberflächenschichten 3, 4, also in der Siliciumschicht 2, ein elektrisches Feld erzeugt wird. Durch Anpassen der Intensität des elektrischen Feldes, insbesondere durch Änderung der angelegten Spannung, kann die phasenverschiebende Wirkung der Phasenplatte verändert werden. Jede der Schichten ist scheibenförmig.

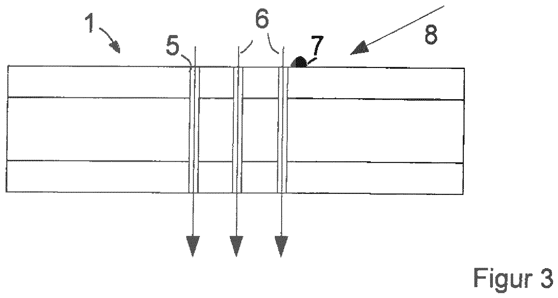

Mit Bezug auf Figur 3 wird die Herstellung der Phasenplatte 1 noch näher erläutert. Zunächst wird der Schichtaufbau hergestellt, indem die Siliciumschicht 2 auf beiden Seiten mit den Oberflächenschichten 3, 4 beschichtet wird. Anschließend werden parallel zur Zylinderachse, d.h. senkrecht zu den scheibenförmigen Schichten 2, 3, 4, fokussierte Ionenstrahlen 6 auf die Schichten 2, 3, 4 aufgebracht. Wo die fokussierten Ionenstrahlen 6 auf die Schichten 2, 3, 4 treffen wird Material von den jeweiligen Schichten abgetragen, bis die Löcher 5 in den Schichten ausgebildet sind. Die Löcher durchbrechen die Schichten 2, 3, 4 vollständig. Während der Behandlung mit den fokussierten Ionenstrahlen können Verdickungen am Rand der Behandlungszonen, also am Rand der erzeugten Löcher, entstehen, von denen beispielhaft eine Verdickung 7 gezeigt ist. Diese Verdickungen können aus Kohlenstoffverbindungen oder andern amorphen Materialien bestehen, die sich während des Ionenbestrahlens dort ablagern. Diese Kohlenstoffverbindungen sowie andere Verunreinigungen können anschließend durch ein Plasmareinigungsverfahren entfernt werden. Bei den Plasmareinigungsverfahren wird vorzugsweise ein Argon-Sauerstoffplasma 8 verwendet, welches insbesondere Kohlenstoffverbindung wegätzen kann. Da die Phasenplatte ansonsten frei von Kohlenstoffverbindungen ist, wird die Phasenplatte 21 durch das Plasmareinigungsverfahren nicht beschädigt. Zwar umfasst Graphen auch Kohlenstoffatome; diese haben aber aufgrund ihrer Struktur nicht die Nachteile von amorphem Kohlenstoff. Falls die Phasenplatte 1 noch weitere Schichten umfasst, wie beispielsweise nachfolgend dargestellt, werden zuvor diese Schichten, insbesondere sämtliche Schichten, vor dem Einbringen der Löcher auf die Kernschicht zumindest mittelbar aufgetragen.

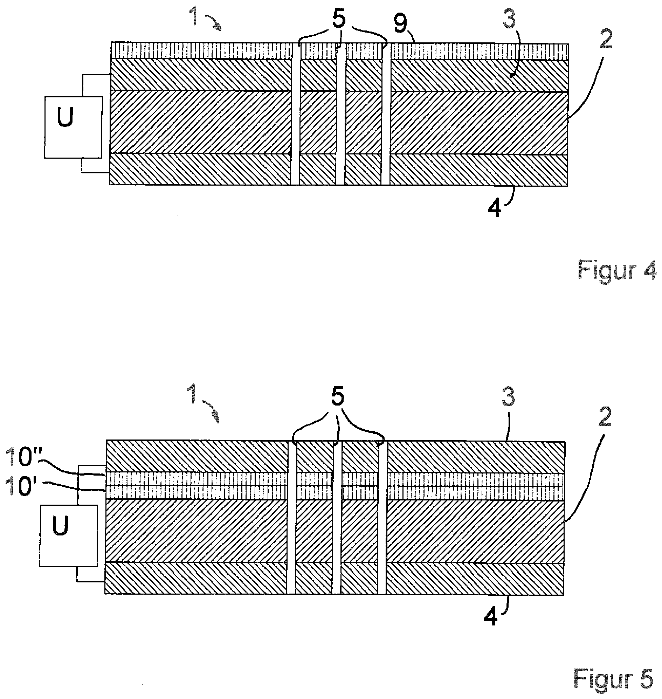

In Figur 4 ist eine Weiterbildung der Phasenplatte nach Figur 1 gezeigt. In diesem Beispiel eignet sich insbesondere Graphen als Werkstoff für die erste Oberflächenschicht 3. Ferner ist auf die erste Oberflächenschicht 3 eine Schutzschicht 9 aufgebracht, die aus einem metallischen Werkstoff gebildet ist. Die Schutzschicht 9 kann eine Fixierung der Graphenschicht 3 begünstigen und/oder die Einbringung der Löcher 5 erleichtern. Die Graphenschicht 3 sowie die die Schutzschicht 9 kann auch auf die andere Seite der Kernschicht angewendet werden, so dass auch die zweite Oberflächenschicht 4, die vorzugsweise auch aus Graphen gebildet ist, mit einer nicht dargestellten Schutzschicht bedeckt sein kann.

In Figur 5 ist eine weitere Weiterbildung der Phasenplatte nach Figur 1 gezeigt. Zwischen der ersten Oberflächenschicht 3 und der Kernschicht 2 sind zwei Zwischenschichten 10 angebracht. Die erste Zwischenschicht 10' ist aus einem leitenden, insbesondere metallischen Werkstoff oder Graphen gebildet und ist der Kernschicht 2 zugewandt. Die zweite Zwischenschicht 10' ist aus einem isolierenden Werkstoff gebildet und der ersten Oberflächenschicht 3 zugewandt. Die zweite Zwischenschicht 10" kann insbesondere aus DLC (dimondlike carbon) oder Alumoiniumoxid (Al₂O₃) gebildet sein. Der verwendete Kohlenstoff wird dabei aufgrund seiner Anordnung im inneren der Phasenplatte nicht durch das äußerlich wirkende Reinigungsplasma angegriffen. Durch die Verwendung der leitenden Zwischenschicht 10' kann das elektrische Feld besser ausgerichtet werden. Die isolierende Zwischenschicht 10" dient dabei dazu, dass die Ladung der Oberflächenschicht 3 nicht auf die leitenden Zwischenschicht 10' gelangen kann. Die Zwischenschichten 10 kann auch auf die andere Seite der Kernschicht 2 angewendet werden, so dass dort die gezeigte Anordnung auch gegeben ist.

### Bezugszeichenliste

- 1: Phasenplatte
- 2: Siliciumschicht
- 3: erste Oberflächenschicht
- 4: zweite Oberflächenschicht
- 5: Loch
- 6: fokussierter Ionenstrahl
- 7: Verdickung
- 8: Argon-Sauerstoffplasma
- 9: Schutzschicht
- 10: Zwischenschicht

- U: Spannungsquelle
- D: Querschnittsdicke

## Patentansprüche

1. Phasenkontrasteinheit (1), insbesondere Phasenplatte, zur Verwendung in einem Elektronenmikroskop,
umfassend
eine Kernschicht (2), wobei während der Verwendung Elektronenstrahlen durch die Kernschicht durchtreten,
**dadurch gekennzeichnet, dass** die Phasenkontrasteinheit eine erste Oberflächenschicht (3) und eine zweite Oberflächenschicht (4) umfasst, wobei die erste und die zweite Oberflächenschicht an entgegengesetzten Seiten der Kernschicht (2) angebracht sind,
wobei die Schichten (2, 3, 4) durch zumindest ein Loch (5) durchbrochen sind,
und
dass die erste und die zweite Oberflächenschicht (3, 4) jeweils elektrisch leitend sind und gegeneinander isoliert sind.

2. Phasenkontrasteinheit nach dem vorherigen Anspruch, **dadurch gekennzeichnet, dass** sämtliche Schichten der Phasenkontrasteinheit in einem Bauteil zusammengefasst sind.

3. Phasenkontrasteinheit nach einem der vorherigen Ansprüche, **dadurch gekennzeichnet, dass** an die erste und/oder die zweite Oberflächenschicht (3, 4) oder an beide Oberflächenschichten eine elektrische Spannung anlegbar ist, insbesondere eine Spannung angelegt ist.

4. Phasenkontrasteinheit nach einem der vorherigen Ansprüche, **dadurch gekennzeichnet, dass** die Kernschicht (2) aus einem Isolator gebildet ist.

5. Phasenkontrasteinheit nach einem der vorherigen Ansprüche, dass zwischen einer der Oberflächenschichten (3, 4) und der Kernschicht (2) eine oder mehrere Zwischenschichten (10) angeordnet sind.

6. Phasenkontrasteinheit nach einem der vorherigen Ansprüche, **dadurch gekennzeichnet, dass** eine der Oberflächenschichten (3, 4) oder eine Zwischenschicht (10) aus Graphen, insbesondere monomofekularem Graphen gebildet ist.

7. Phasenkontrasteinheit nach einem der vorherigen Ansprüche, **dadurch gekennzeichnet, dass** die Kernschicht (2) aus einem amorphen Material gebildet ist, insbesondere aus amorphem Silicium.

8. Phasenplatte nach einem der vorherigen Ansprüche, **dadurch gekennzeichnet, dass** die Querschnittsdicke (D₂) der Kernschicht (2) geringer als 10nm, vorzugsweise maximal 5nm ist.

9. Phasenkontrasteinheit nach einem der vorherigen Ansprüche, **dadurch gekennzeichnet, dass** eine Querschnittsdicke (D₁) der Phasenkontrasteinheit (1) maximal 15nm beträgt.

10. Elektronenmikroskop, umfassend eine Phasenkostrasteinheit nach einem der Ansprüche 1 bis 9.

11. Verfahren zum Herstellen einer Phasenkontrasteinheit nach Anspruch 1, insbesondere Phasenplatte, umfassend die folgenden Verfahrensschritte:
Beschichten einer ersten Seite einer Kernschicht (2) mit einer ersten leitenden Oberflächenschicht (3),
Beschichten einer zweiten Seite der Kernschicht (2) mit einer zweiten leitenden Oberflächenschicht (4),
wobei die erste und die zweite Oberflächenschicht gegeneinander isoliert sind, Einbringen von zumindest einem Loch (5) durch die Schichten (2, 3, 4).

12. Verfahren nach dem vorherigen Anspruch, **dadurch gekennzeichnet, dass** das zumindest eine Loch (5) durch einen, insbesondere fokussierten, Ionenstrahl erzeugt wird.

13. Verfahren nach einem der Ansprüche 11 oder 12, **dadurch gekennzeichnet, dass** nach dem Einbringen von dem zumindest einem Loch (5) die Phasenkontrasteinheit (1) einem Plasmareinigungsverfahren unterzogen wird, insbesondere mit einem Argon-Sauerstoffplasma gereinigt wird.

## Claims

1. Phase contrast unit (1), in particular a phase plate for use in an electron microscope,
comprising a core layer (2), wherein electron beams pass through the core layer during use,
**characterised in that**
the phase contrast unit comprises a first surface layer (3) and a second surface layer (4), wherein the first and the second surface layers are fitted on opposite sides of the core layer (2),
wherein the layers (2, 3, 4) are perforated by at least one hole (5), and
that the first and the second surface layers (3, 4) are in each case electrically conductive and insulated from one another.

2. Phase contrast unit according to the preceding claim, **characterised in that** all layers of the phase contrast unit are combined in a single component.

3. Phase contrast unit according to one of the preceding claims, **characterised in that** a voltage can be applied, in particular a voltage is applied to the first and/or second surface layer (3, 4) or to both surface layers.

4. Phase contrast unit according to one of the preceding claims, **characterised in that** the core layer (2) is made from an insulator.

5. Phase contrast unit according to one of the preceding claims, **characterised in that** one or more intermediate layers (10) are arranged between one of the surface layers (3, 4) and the core layer (2).

6. Phase contrast unit according to one of the preceding claims, **characterised in that** one of the surface layers (3, 4) or an intermediate layer (10) is made of graphene, particularly monomolecular graphene.

7. Phase contrast unit according to one of the preceding claims, **characterised in that** the core layer (2) is made of an amorphous material, particularly amorphous silicon.

8. Phase plate according to one of the preceding claims, **characterised in that** the cross-sectional thickness (D₂) of the core layer (2) is less than 10 nm, preferably not more than 5nm.

9. Phase contrast unit according to one of the preceding claims, **characterised in that** a cross-sectional thickness (D₁) of the phase contrast unit (1) is not more than 15 nm.

10. Electron microscope comprising a phase contrast unit according to any of claims 1 to 9.

11. Method for manufacturing a phase contrast unit according to claim 1, in particular the phase plate, comprising the steps of:
Coating a first side of a core layer (2) with a first conductive surface layer (3),
Coating a second side of the core layer (2) with a second conductive surface layer (4),
wherein the first and second surface layers are insulated from each other,
creating at least one hole (5) that passes through the layers (2, 3, 4).

12. Method according to the preceding claim, **characterised in that** the at least one hole (5) is created by an ion beam, in particular a focused ion beam.

13. Method according to one of claims 11 or 12, **characterised in that** after the creation of the at least one hole (5) the phase contrast unit (1) undergoes a plasma cleaning process, in particular it is cleaned with an argon-oxygen plasma.

## Revendications

1. Unité en contraste de phase (1), notamment lame de phase, destinée à être utilisée dans un microscope électronique, comprenant une couche d'âme (2), pendant l'utilisation, des rayons électroniques traversant la couche d'âme, **caractérisée en ce que** l'unité en contraste de phase comprend une première couche superficielle (3) et une deuxième couche superficielle (4), la première et la deuxième couches superficielles étant montées sur des faces opposées de la couche d'âme (2),
les couches (2, 3, 4) étant percées par au moins un trou (5) et
**en ce que** la première et la deuxième couches superficielles (3, 4) sont respectivement conductrices d'électricité et sont isolées l'une par rapport à l'autre.

2. Unité en contraste de phase selon la revendication précédente, **caractérisée en ce que** toutes les couches de l'unité en contraste de phase sont rassemblées dans un élément constructif.

3. Unité en contraste de phase selon l'une quelconque des revendications précédentes, **caractérisée en ce qu'**une tension électrique est applicable, notamment une tension électrique est appliquée sur la première et/ou sur la deuxième couche superficielle (3, 4) ou sur les deux couches superficielles.

4. Unité en contraste de phase selon l'une quelconque des revendications précédentes, **caractérisée en ce que** la couche d'âme (2) est formée d'un isolateur.

5. Unité en contraste de phase selon l'une quelconque des revendications précédentes, **caractérisée en ce qu'**entre l'une des couches superficielles (3, 4) et la couche d'âme (2) sont placées une ou plusieurs couches intermédiaires (10).

6. Unité en contraste de phase selon l'une quelconque des revendications précédentes, **caractérisée en ce que** l'une des couches superficielles (3, 4) ou une couche intermédiaire (10) est constituée de graphène, notamment de graphène mono-moléculaire.

7. Unité en contraste de phase selon l'une quelconque des revendications précédentes, **caractérisée en ce que** la couche d'âme (2) est formée d'une matière amorphe, notamment de silicium amorphe.

8. Lame de phase selon l'une quelconque des revendications précédentes, **caractérisée en ce que** l'épaisseur de section transversale (D₂) de la couche d'âme (2) est inférieure à 10 nm, de préférence d'un maximum de 5 nm.

9. Unité en contraste de phase selon l'une quelconque des revendications précédentes, **caractérisée en ce qu'**une épaisseur de section transversale (D₁) de l'unité en contraste de phase (1) s'élève au maximum à 15 nm.

10. Microscope électronique, comprenant une unité en contraste de phase selon l'une quelconque des revendications 1 à 9.

11. Procédé destiné à fabriquer une unité en contraste de phase selon la revendication 1,
notamment lame de phase,
comprenant les étapes de procédé suivantes :
du revêtement d'une première face d'une couche d'âme (2) avec une première couche superficielle (3) conductrice,
du revêtement d'une deuxième face de la couche d'âme (2) avec une deuxième couche superficielle (4) conductrice,
la première et la deuxième couches superficielles étant isolées l'une par rapport à l'autre,
du ménagement d'au moins un trou (5) à travers les couches (2, 3, 4).

12. Procédé selon la revendication précédente, **caractérisé en ce que** l'au moins un trou (5) est créé par un faisceau ionique, notamment focalisé.

13. Procédé selon l'une quelconque des revendications 11 ou 12, **caractérisé en ce qu'**après le ménagement de l'au moins un trou (5), l'unité en contraste de phase (1) est soumise à un procédé de nettoyage au plasma, notamment est nettoyée avec un plasma argon - oxygène.
